# EUROPEAN PATENT APPLICATION

(11) **EP 0 895 238 A2**
(43) Date of publication of application: **03.02.1999**
(21) Application number: 98305684.7
(22) Date of filing: 16.07.1998
(51) Int. Cl.: G11B 20/10

(54) **Error compensation circuit for compensating for parameter errors of IC chip having filter and boost circuit**

(30) Priority: 02.08.1997 KR 9737102
(71) Applicant: Samsung Electronics Co., Ltd., Suwon City, Kyungki-do (KR)
(72) Inventor: Kim, Chun-Sup, Suwon-shi, Kyonggi-do (KR)
(74) Representative: Chugg, David John

(57) **Abstract**

An error compensation circuit for compensating for a frequency error and a boost error of an IC chip having a filter (30) and a boost circuit (40). The error compensation circuit includes a frequency compensation circuit (50, 70), a boost compensation circuit (60, 70), and a switch being switchable in response to a mode control signal. The frequency compensation circuit (50, 70) includes a first level detector (51-53) for detecting a level of a signal output from the filter (30); a first level comparator (55) for comparing an output level of the first level detector (51-53) with a reference signal level (54); a first integrator (56) for integrating an output of the first level comparator (55) to generate a frequency error signal; and a first data storage (72a, 74a, 76a) for converting the frequency error signal into digital data, storing the digital data, converting the stored digital data into an analog frequency compensation signal in the normal signal processing mode, and providing the frequency compensation signal to the filter (30). The boost compensation circuit includes a second level detector for detecting a level of a signal output from the boost circuit; a second level comparator for comparing an output level of the second level detector with the reference signal level; a second integrator for integrating an output of the second level comparator to generate a boosting error signal; and a second data storage for converting the boosting error signal into digital data, storing the digital data, converting the stored digital data into an analog boost compensation signal in the normal signal processing mode, and providing the boost compensation signal to the boost circuit (40).

## Description

The present invention relates to a compensation for parameter errors (or processing errors) of elements, which may be generated in the fabrication process of an integrated circuit (IC) chip, and in particular, to an error compensation circuit for compensating for a frequency error of a filter and a boosting error of a boost circuit in an equalizer IC chip for use in an optical disk player.

An optical disk player such as a DVD (Digital Video Disk) player includes an equalizer filter for use in a read channel. As to the equalizer filter, it is necessary to reduce a permissible error of a frequency characteristic and a boosting gain, as much as possible. However, during the process of fabricating an IC chip including the equalizer filter, parameters of the elements such as resistors, capacitors and transistors may be deviated by over +/-20% from the designed parameters. As the result, in the worst case, the frequency characteristic and the boosting gain of the equalizer filter may deviate far from the designed values, exceeding the permissible error. Accordingly, prior to the shipment of the IC chip, it is necessary to detect parameter errors (i.e., processing errors) generated during the manufacturing process and compensate for the deviation (i.e., the parameter errors), so as to optimize the frequency characteristic and the boosting level.

It is therefore an aim of preferred embodiments of the present invention to provide an error compensation circuit capable of detecting parameter errors generated in the process of manufacturing an IC chip having a filter and a boost circuit and automatically compensating for deviation from designed parameters.

It is another aim of preferred embodiments of the present invention to provide an error compensation circuit for optimally maintaining a frequency characteristic and a boost level of an IC chip having an equalizer filter for use in a read channel of an optical disk player.

According to an aspect of the present invention, there is provided an error compensation circuit for compensating for a parameter error of an IC (Integrated Circuit) chip having a filter for filtering a read signal input, comprising: a level detector for detecting a level of a signal output from said filter; a level comparator for comparing an output level of said level detector with a reference signal level; an integrator for integrating an output of said level comparator to generate a frequency error signal; a data storage for converting said frequency error signal into digital data, storing the digital data, converting the stored digital data into an analog frequency compensation signal in a normal signal processing mode, and providing said frequency compensation signal to the filter; and a switch (SW) with a common end connected to the filter, for switching the common end to the reference signal in an error compensation mode and to a read signal in the normal signal processing mode.

According to a second aspect of the present invention, there is provided an error compensation circuit for compensating for a parameter error of an IC chip having a boost circuit for boosting up an input signal of a given frequency with a predetermined gain said error compensation circuit, comprising: a level detector for detecting a level of a signal output from said boost circuit; a level comparator for comparing an output level of said level detector with a reference signal level; an integrator for integrating an output of said level comparator to generate a boost error signal; and a data storage for converting said boost error signal into digital data, storing the digital data, converting the stored digital data into an analog boost compensation signal in a normal signal processing mode, and providing said boost compensation signal to the boost circuit.

Preferably, said level detector comprises: a peak detector for detecting a peak value of the signal output from the filter; a bottom detector for detecting a bottom value of the signal output from the filter; and a differential amplifier for amplifying a level difference between the peak value and the bottom value.

According to a third aspect of the present invention, there is provided an error compensation circuit for compensating for parameter errors of an IC chip having a filter for filtering a read signal input and a boost circuit for boosting up a signal output from the filter with a predetermined gain, comprising: a frequency compensation circuit including; a first level detector for detecting a level of a signal output from said filter; a first level comparator for comparing an output level of said first level detector with a reference signal level; a first integrator for integrating an output of said first level comparator to generate a frequency error signal; a first data storage for converting said frequency error signal into digital data, storing the digital data, converting the stored digital data into an analog frequency compensation signal in a normal signal processing mode, and providing said frequency compensation signal to the filter; a boost compensation circuit including: a second level detector for detecting a level of a signal output from said boost circuit; a second level comparator for comparing an output level of said second level detector with said reference signal level; a second integrator for integrating an output of said second level comparator to generate a boosting error signal; a second data storage for converting said boosting error signal into digital data, storing the digital data, converting the stored digital data into an analog boost compensation signal in the normal signal processing mode, and providing said boost compensation signal to the boost circuit; and a switch (SW) with a common end connected to the filter, for switching the common end to the reference signal in an error compensation mode and to the read signal in the normal signal processing mode.

Preferably, a reference signal level detector is provided for detecting the reference signal level in the error compensation mode.

For a better understanding of the invention, and to show how embodiments of the same may be carried into effect, reference will now be made, by way of example, to the accompanying diagrammatic drawings, in which:
Figure 1 is a block diagram of an equalizer IC chip according to an embodiment of the present invention;
FIGs. 2A and 2B are diagrams illustrating output characteristics of a lowpass filter (30) and a boost circuit (40) of Figure 1, respectively;
Figure 3 is a block diagram of a frequency error detector (50) of Figure 1; and
Figure 4 is a block diagram of a data storage (70) of Figure 1.

A preferred embodiment of the present invention will be described in detail hereinbelow with reference to the accompanying drawings. In the following description, numerous specific details are set forth to provide a more thorough understanding of the present invention. It will be apparent, however, to one skilled in the art that the present invention may be practised without these specific details. In other instances, well known functions or constructions have not been described so as not to obscure the present invention.

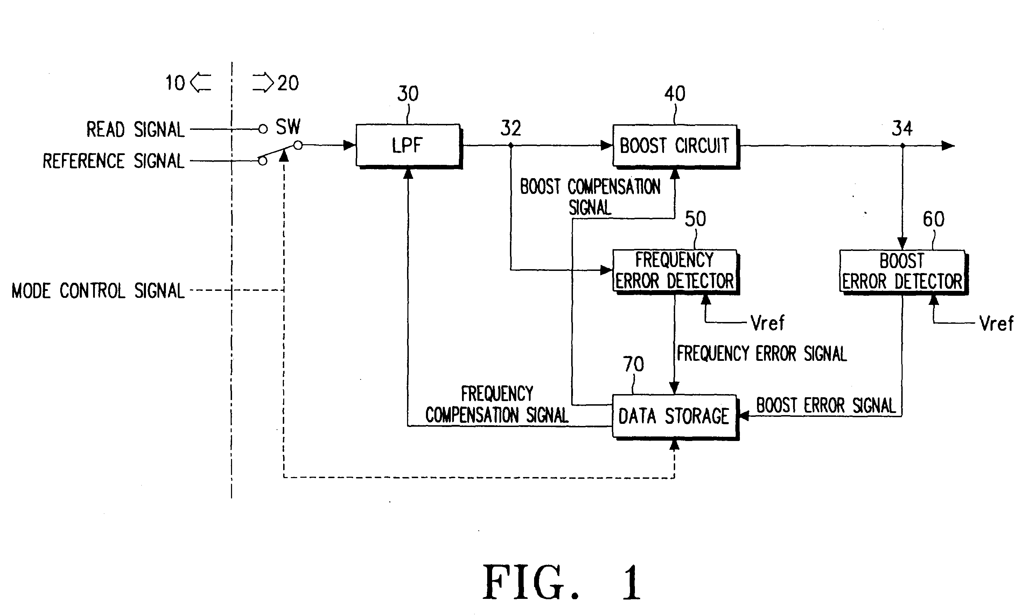

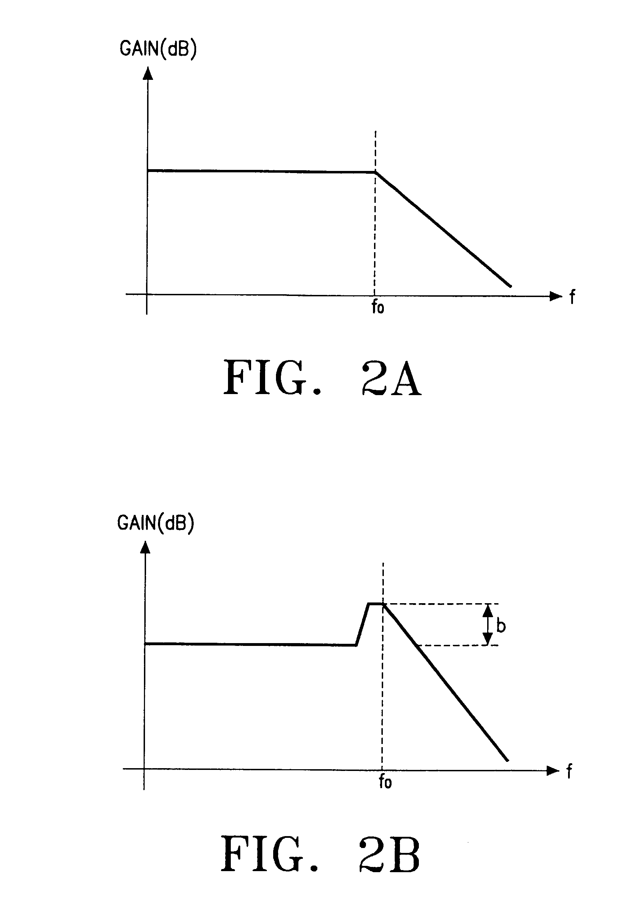

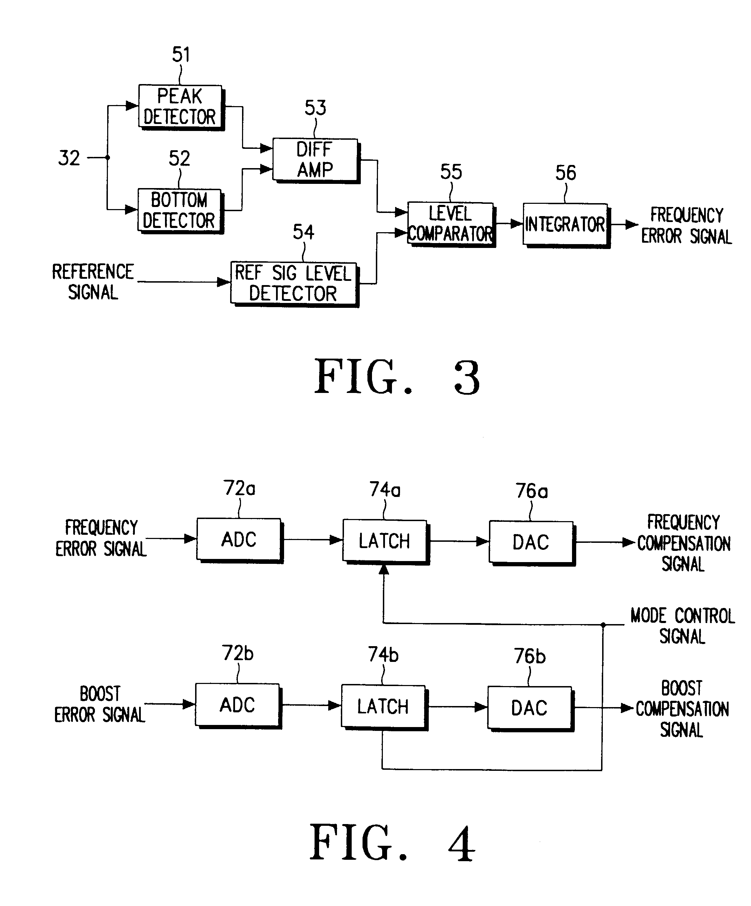

Figure 1 illustrates a block diagram of an equalizer IC chip according to an embodiment of the present invention. FIGs. FIGs. 2A and 2B illustrate output characteristics of a lowpass filter 30 and a boost circuit 40 of Figure 1, respectively. Figure 3 shows a block diagram of a frequency error detector 50 of Figure 1, and Figure 4 shows a block diagram of a data storage 70 of Figure 1.

Referring to Figure 1, reference numerals 10 and 20 denote the exterior and interior of the equalizer IC chip, respectively. As illustrated, the equalizer IC chip includes a lowpass filter (LPF) 30 for lowpass filtering a read signal input from an optical disk, and a boost circuit 40 for boosting up a level of a lowpass filtered signal 32 from the lowpass filter 30 with a predetermined boosting gain. The lowpass filter 30 and the boost circuit 40 have the output characteristics as shown in FIGs. 2A and 2B, respectively. Further, the equalizer IC chip includes an error compensation circuit composed of a frequency error detector 50, a boost error detector 60, a data storage 70, and a switch SW. The switch SW has a movable end (or a common end) connected to an input end of the lowpass filter 30, a fixed end connected to the read signal input from the optical disk, and another fixed end connected to a reference signal Vref for compensating for the parameter errors of the lowpass filter 30 and the boost circuit 40, being generated in the manufacturing process. The switch SW is switchable in response to a mode control signal input from the exterior of the equalizer IC chip. The mode control signal is used in detecting the parameter errors generated in the manufacturing process of the equalizer IC chip to compensate for the detected parameter errors. In the following description, it should be noted that the switch SW is switched to the reference signal Vref in an error compensation mode and to the read signal in a normal signal processing mode. Besides, the frequency error detector 50 has a construction as shown in Figure 3.

Referring to Figure 3, a peak detector 51 detects a peak value of the lowpass filtered signal 32 and a bottom detector 52 detects a bottom value of the lowpass filtered signal 32. A differential amplifier 53 amplifies a level difference between the peak value output from the peak detector 51 and the bottom value output from the bottom detector 52. A level comparator 55 compares an output level of the differential amplifier 53 with a reference signal level Vref input through a reference signal level detector 54. The reference signal level detector 54 detects the level of the reference signal Vref input during the error compensation mode. However, at the chip designer's option, the reference signal Vref may be directly applied to the level comparator 55, without passing through the reference signal level detector 54. By comparing the reference signal Vref with the output of the differential amplifier 53, the level comparator 55 detects the parameter error (i.e., the frequency error) according to the manufacturing process and generates a pulse signal. An integrator 56 integrates the pulse signal output from the level comparator 55 to generate an analog frequency error signal.

Referring back to Figure 1, though not illustrated, the boost error detector 60 has the same construction as that of the frequency error detector 50. That is, the boost error detector 60 compares a boost signal 34 of the boost circuit 40 with the reference signal Vref and integrates the pulse signal generated according to the comparison, to generate an analog boost error signal. Further, the data storage 70 is constructed as shown in Figure 4.

Referring to Figure 4, the data storage 70 is composed of an analog-to-digital converter (ADC) 72a, 72b, a latch 74a, 74b and a digital-to-analog-converter (DAC) 76a, 76b. The ADC 72 converts the analog frequency error signal and the analog boost error signal from the frequency error detector 50 and the boost error detector 60 into digital frequency error data and digital boost error data, respectively. The latch 74a, 74b latches the digital frequency error data and the digital boost error data according to the mode control signal input. The DAC 76a, 76b converts digital data output from the latch 74a, 74b into an analog frequency compensation signal and an analog boost compensation signal.

Now, referring to FIGs. 1 through 4, operation of the error compensation circuit will be described in detail.

The equalizer filter used for a read channel of the DVD player is subject to the following parameter compensation before a normal signal processing. First, the activated mode control signal is applied to the equalizer IC chip, to switch the common end of switch SW to the reference signal Vref. Then, the reference signal Vref having a specific frequency is lowpass filtered by the lowpass filter 30 of which parameter error is not yet compensated for, and applied to the boost circuit 40 and the frequency error detector 50. The frequency error detector 50 primarily detects the level of the lowpass filtered signal 32. Specifically describing the level detection, referring to Figure 3, the peak detector 51 and the bottom detector 52 detect both the peak and bottom levels of the lowpass filtered signal 32, irrespective of the deviation of the input signal. The level difference between the detected peak and bottom levels is amplified by the differential amplifier 53 and then applied to the level comparator 55. Here, the differential amplifier 53 has a specific gain at a frequency f₀ where its output signal is to be compared with the reference signal Vref. The level comparator 55 compares the output signal of the differential amplifier 53 with the reference signal Vref input through the reference signal level detector 54. Optionally, the reference signal Vref may be directly applied to the level comparator 55, without passing through the reference signal level detector 54. In this case, the reference signal Vref should be controlled such that the gain becomes -3dB at the frequency f₀. The level comparator 55 generates the pulse signal according to the comparison of the reference signal level with the output of the differential amplifier 53. The integrator 56 integrates the pulse signal output from the level comparator 55 to generate the frequency error signal. The frequency error signal is converted by the ADC 72a into the digital data and stored in the latch 74a in response to the mode control signal. The digital data stored in the latch 74a is converted by the DAC 76a into the frequency compensation signal. Coefficients (e.g., transconductance [gm]) of the elements constituting the lowpass filter 30 may vary according to the frequency compensation signal, thereby minimizing the parameter errors. Further, the lowpass filtered signal 32 is boosted up to the signal level 34 at the frequency f₀ by a boosting gain "b" (see Figure 2B). In the same manner as described above, the boost error detector 60 detects and compensates for the boost error of the boost circuit 40. In the meantime, if the mode control signal is inactivated, the common end of the switch SW is switched to the read signal in response to the inactivated mode control signal. Then, the latch 74a, 74b maintains (or latches) the digital data stored therein in response to the inactivated mode control signal, so that the frequency characteristic of the lowpass filter 30 and the boosting level of the boost circuit 40 may be maintained within the permissible range of the designed parameter.

As described above, the error compensation circuit of the invention automatically compensates for the parameter errors (i.e., frequency error and boost error), in case the frequency characteristic of the filter and the boosting level of boost circuit are deviated from the permissible range of the designed parameters due to the characteristic change of the resistors, capacitors, and transistors during the manufacturing process of the IC chip. Therefore, it is possible to maintain the frequency characteristic of the filter and the boosting level of the boost circuit within the permissible range of the designed parameters.

While the present invention has been described in detail with reference to the specific embodiments, they are mere exemplary applications. Thus, it is to be clearly understood that many variations can be made by anyone skilled in the art within the scope of the present invention.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. An error compensation circuit for compensating for a parameter error of an IC (Integrated Circuit) chip having a filter (30) for filtering a read signal input, comprising:
a level detector (51-53) for detecting a level of a signal output from said filter (30);
a level comparator (55) for comparing an output level of said level detector (51-53) with a reference signal level (54);
an integrator (56) for integrating an output of said level comparator (55) to generate a frequency error signal;
a data storage (70) for converting said frequency error signal into digital data, storing the digital data, converting the stored digital data into an analog frequency compensation signal in a normal signal processing mode, and providing said frequency compensation signal to the filter (30); and
a switch (SW) with a common end connected to the filter (30), for switching the common end to the reference signal in an error compensation mode and to a read signal in the normal signal processing mode.

2. An error compensation circuit for compensating for a parameter error of an IC chip having a boost circuit (40) for boosting up an input signal of a given frequency with a predetermined gain said error compensation circuit, comprising:
a level detector for detecting a level of a signal output from said boost circuit;
a level comparator for comparing an output level of said level detector with a reference signal level;
an integrator for integrating an output of said level comparator to generate a boost error signal; and
a data storage (70) for converting said boost error signal into digital data, storing the digital data, converting the stored digital data into an analog boost compensation signal in a normal signal processing mode, and providing said boost compensation signal to the boost circuit.

3. The error compensation circuit as claimed in claim 1 or 2, wherein said level detector comprises:
a peak detector (51) for detecting a peak value of the signal output from the filter (30);
a bottom detector (52) for detecting a bottom value of the signal output from the filter (30); and
a differential amplifier (53) for amplifying a level difference between the peak value and the bottom value.

4. An error compensation circuit for compensating for parameter errors of an IC chip having a filter for filtering a read signal input and a boost circuit for boosting up a signal output from the filter with a predetermined gain, comprising:
a frequency compensation circuit including;
a first level detector (51-53) for detecting a level of a signal output from said filter;
a first level comparator (55) for comparing an output level of said first level detector (51-53) with a reference signal level (54);
a first integrator (56) for integrating an output of said first level comparator (55) to generate a frequency error signal;
a first data storage (72a, 74a, 76a) for converting said frequency error signal into digital data, storing the digital data, converting the stored digital data into an analog frequency compensation signal in a normal signal processing mode, and providing said frequency compensation signal to the filter (30);
a boost compensation circuit including:
a second level detector for detecting a level of a signal output from said boost circuit;
a second level comparator for comparing an output level of said second level detector with said reference signal level;
a second integrator for integrating an output of said second level comparator to generate a boosting error signal;
a second data storage (72b, 74b, 76b) for converting said boosting error signal into digital data, storing the digital data, converting the stored digital data into an analog boost compensation signal in the normal signal processing mode, and providing said boost compensation signal to the boost circuit (40); and
a switch (SW) with a common end connected to the filter (30), for switching the common end to the reference signal in an error compensation mode and to the read signal in the normal signal processing mode.

5. The error compensation circuit as claimed in claim 4, further comprising a reference signal level detector for detecting the reference signal level in the error compensation mode.
